Europäisches Patentamt

European Patent Office

Office européen des brevets

(19)

(11) Publication number : **0 520 598 A1**

## (12) EUROPEAN PATENT APPLICATION

(21) Application number : **92250169.7**

(22) Date of filing : **26.06.92**

(51) Int. Cl.$^5$ : **B41F 27/00, G03F 9/00**

(30) Priority : **27.06.91 JP 57095/91 U**

(43) Date of publication of application :
**30.12.92 Bulletin 92/53**

(84) Designated Contracting States :
**AT CH DE FR GB IT LI NL SE**

(71) Applicant : **Komori Corporation
11-1, Azumabashi 3-chome
Sumida-ku Tokyo (JP)**

(72) Inventor : **Murakami, Toshiyuki, c/o Toride
Plant
Komori Corporation, 5-1, Higashi 4-chome
Toride-shi, Ibaraki (JP)**

(74) Representative : **Patentanwälte Wenzel &
Kalkoff
Grubes Allee 26 Postfach 730466
W-2000 Hamburg 73 (DE)**

(54) **Plate for printing press or the like.**

(57)    A plate (1) includes reference pin holes (3, 5)
and chamfered portions (3a, 5a). The reference
pin holes are formed in ends (1a, 1b) of the plate
to engage with reference pins (15, 24) of a plate
cylinder (6). The chamfered portions are formed
to spread toward open ends of the reference pin
holes.

F I G.1

EP 0 520 598 A1

## Background of the Invention

The present invention relates to a plate constituted by a thin metal plate or the like and mounted on a plate cylinder when the two ends of the plate are gripped by plate lockup devices of the plate cylinder and wound on the circumferential surface of the plate cylinder.

Leading- and trailing-side plate lockup devices extending in the axial direction of a plate cylinder of a sheet printing press or the like are disposed in a gap in the circumferential surface of the plate cylinder to be parallel with each other. A plate is wound on the circumferential surface of the plate cylinder after one end of the plate is gripped by the leading-side plate lockup device, and is mounted on the plate cylinder when the other end of the plate is gripped by the trailing-side plate lockup device.

In a multicolor printing press having a plurality of printing units, if printing registrations of the plates mounted on the plate cylinders of the respective printing units do not coincide with each other, the quality of the printed matter is degraded. For this reason, conventionally, reference pin holes to be engaged with reference pins extending on the plate cylinder are formed in the plate, and the plate is mounted on the plate cylinder while engaging these reference pins with the corresponding reference pin holes.

That is, in general, a pattern is formed on a plate of each color by a process device, and U-shaped reference pin holes are formed at two portions, e.g., right and left portions of the leading end and the central portion of the trailing end of the plate of each color to open to the corresponding ends by a borer to precisely maintain the relative positional relationship with the pattern. Reference pins biased by spring members in a projecting direction are inserted in the pin holes formed in the leading- and trailing-side plate lockup devices of the plate cylinder. To mount the plate on the plate cylinder, the leading end of the plate is inserted between the gripper surfaces of the plate lockup devices, the bottom surfaces of the reference pin holes are urged against the reference pins, and the gripper surfaces are closed. Then, the plate is gripped while it is correctly positioned in the lateral and vertical directions. Thereafter, the plate is wound on the circumferential surface of the cylinder, and its trailing end is gripped by the trailing-side plate lockup device while engaging the trailing-side reference pin with the reference pin hole, thereby mounting the plate on the plate cylinder.

In the conventional plate of this type, however, the reference pin holes and the reference pins are formed with very high dimensional precision to provide tight engagement, so that registration precision is maintained. Therefore, it is difficult and time-consuming to completely engage these reference pin holes with the reference pins, requiring special care and posing a mental pressure. In addition, the open end of a reference pin hole is sometimes bent undesirably to catch the tooth of a gripper surface, thus interfering with insertion of the plate. As a result, automatization of the plate exchange operation which is recently under development is barred.

## Summary of the Invention

It is an object of the present invention to provide a plate which can be easily mounted on a plate cylinder to decrease the labor load.

It is another object of the present invention to provide a plate whose preparation time required for mounting on a plate cylinder is shortened to improve the operating efficiency of the printing press.

It is still another object of the present invention to provide a plate optimum for automatization of plate exchange.

In order to achieve the above objects, according to the present invention, there is provided a plate comprising reference pin holes formed in ends of the plate to engage with reference pins of a plate cylinder, and chamfered portions formed to spread toward open ends of the reference pin holes.

## Brief Description of the Drawings

Fig. 1 is a developed plan view showing a plate according to an embodiment of the present invention, in which reference pin holes are engaged with reference pins;

Fig. 2 is an enlarged plan view of a reference pin hole shown in Fig. 1;

Fig. 3 is a schematic plan view of a plate cylinder of a printing press;

Fig. 4 is a longitudinal sectional view of a trailing-side plate lockup device of the plate cylinder; and

Fig. 5 is a longitudinal sectional view of a leading-side plate lockup device of the plate cylinder.

## Detailed Description of the Preferred Embodiment

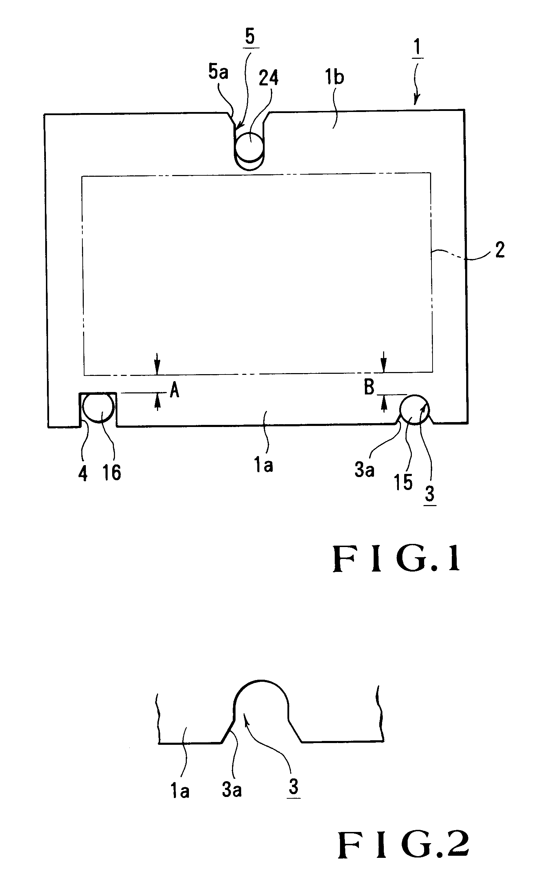

Figs. 1 to 5 show a plate according to an embodiment of the present invention.

Referring to Figs. 1 to 5, a plate 1 is constituted by an aluminum thin plate to have a rectangular shape, and a pattern 2 is formed on its surface by a process device within a range indicated by an alternate long and two short dashed line in Fig. 1. Two reference pin holes 3 and 4 are formed at right and left symmetrical positions of a leading end 1a of the plate 1 by a borer (not shown). The relative positions of the reference pin holes 3 and 4 and the pattern 2 are set to provide a predetermined distance between them. Of the two holes 3 and 4, the reference pin hole 3 has a U shape of a size to tightly fit with a reference pin 15 to be described later, that is, the reference pin hole 3 has a hole diameter slightly larger than the diameter of the reference pin 15, and is open in the leading end 1a of the plate 1. A chamfered portion 3a spreading toward the open end is formed in the opening of the reference pin hole 3.

A gap in the widthwise direction is provided between the circumference of the reference pin hole 4 and a reference pin 16 to be described later, and the reference pin hole 4 has a square shape opening in the leading end 1a of the plate 1. The reference pin holes 3 and 4 are set such that the distances between their bottom surfaces and the pattern 2, that is, distances A and B in Fig. 1 become equal. Furthermore, a reference pin hole 5 is formed at the central position of a trailing end 1b of the plate 1 by the borer (not shown). The relative positions of the reference pin hole 5 and the pattern 2 are set to provide a predetermined distance between them. The reference pin hole 5 has a U shape to tightly fit with a reference pin 24 to be described later and open in the trailing end 1b of the plate 1, in the same manner as the reference pin 3. A chamfered portion 5a spreading toward the open end is formed in the opening of the reference pin hole 5.

Leading- and trailing-side plate lockup devices 7 and 8 extending in the axial direction of a plate cylinder 6 are disposed in a gap 6a formed in the circumferential surface of the plate cylinder 6 to be parallel with each other. Of the two devices 7 and 8, the leading-side plate lockup device 7 has a plate lockup table 9, having a substantially square section and fixed on the bottom surface of the gap 6a, and a gripper plate 11 swingably supported on the plate lockup table 9 by pins 10 having arcuated heads. A pin holder 12 is fixed on the lower portions of the swingable end portion of the gripper plate 11 by bolts 13. Reference numeral 14 denotes a cam shaft pivotally engaged in the arcuated head defined by the gripper plate 11 and the plate lockup table 9. The cam shaft 14 has a notch 14a. When a wrench is inserted in the hole of a flange 14b of the cam shaft 14 and turned, the gripper plate 11 swings because of the operation of the notch 14a, and gripper surfaces 11a and 12a formed on the gripper plate 11 and the pin holder 12 are opened and closed to grip one end of the plate 1. A spring member (not shown) for biasing the gripper plate 11 in an opening direction is interposed between the plate lockup table 9 and the gripper plate 11.

A pair of pin holes 12b perpendicular to the gripper surface 12a are formed in the pin holder 12. The reference pins 15 and 16 are fitted in the pin holes 12b to be capable of moving forward and backward to highly precisely correspond to the positions of the reference pin holes 3 and 4 of the plate 1. The reference pins 15 and 16 are biased by compression coil springs 17 interposed between the end faces of the reference pins 15 and 16 and the bottom surface of the gap 6a. Engaging holes for stopping the distal end portions of the reference pins 15 and 16 are formed in the lower surface of the gripper plate 11.

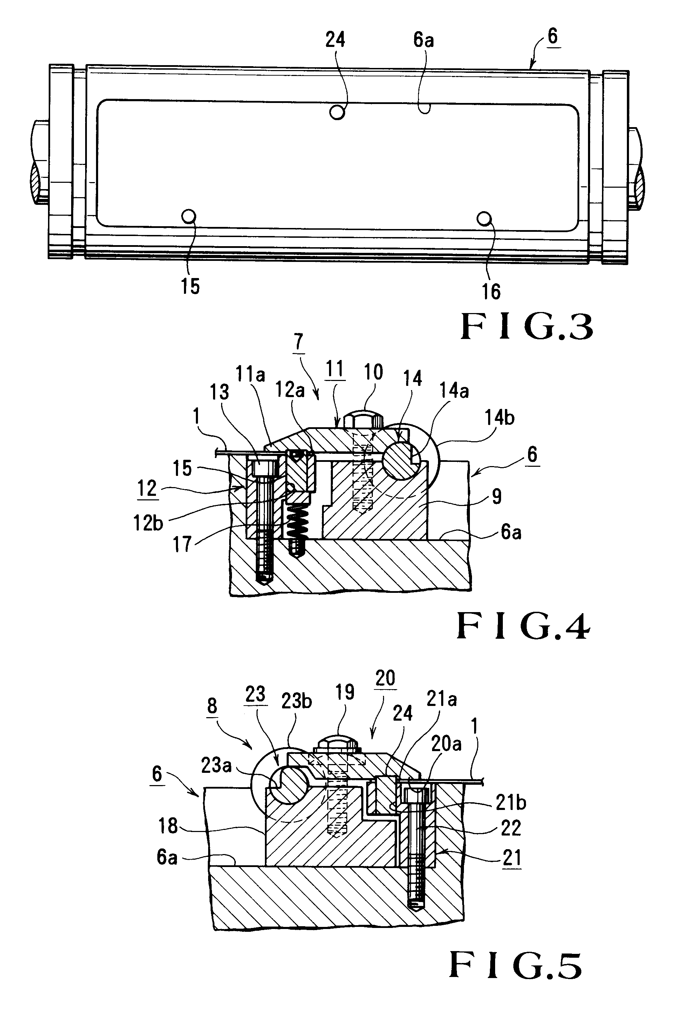

The leading-side plate lockup device 8 has a plate lockup table 18 having a substantially square section and fixed on the bottom surface of the gap 6a, as shown in Fig. 5, and a gripper plate 20 swingably supported on the plate lockup table 18 by pins 19 having arcuated heads. A pin holder 21 is fixed on the lower portions of the swingable end portion of the gripper plate 20 by bolts 22. Reference numeral. 23 denotes a cam shaft pivotally engaged in the arcuated head defined by the gripper plate 20 and the plate lockup table 18. The cam shaft 23 has a notch 23a. When a wrench is inserted in the hole of a flange 23b of the cam shaft 23 and turned, the gripper plate 20 swings because of the operation of the notch 23a, and gripper surfaces 20a and 21a formed on the gripper plate 20 and the pin holder 21 are opened and closed to grip the other end of the plate 1. A spring member (not shown) for biasing the gripper plate 20 in an opening direction is interposed between the plate lockup table 18 and the gripper plate 20.

A pin hole 21b perpendicular to the gripper surface 21a is formed in the pin holder 21. The reference pin 24 is urged to fit in the pin hole 21b to highly precisely correspond to the position of the reference pin hole 5 of the plate 1. An engaging hole for stopping the distal end portion of the reference pin 24 is formed in the lower surface of the gripper plate 20.

The plate mounting operation of a plate lockup apparatus having the above arrangement will be described. When the cam shaft 14 of the leading-side plate lockup device 7 is rotated from the state shown in Fig. 4 to set the notch 14a of the cam shaft 14 to correspond to the end portion of the gripper plate 11, the gripper plate 11 is swung by the spring member (not shown) to open. The leading end of the plate 1 is inserted between the gripper surfaces 11a and 12a, the reference pin holes 3 and 4 are engaged with the reference pins 15 and 16, respectively, so that the bottom surfaces of the reference pin holes 3 and 4 abut against the reference pins 15 and 16, respectively. When the cam shaft 14 is rotated to urge the gripper plate 11 by the arcuated portion of the cam shaft 14, the gripper plate 11 is closed against the elastic force of the spring member. As a result, the plate 1 is gripped by the gripper surfaces 11a and 12a. In this case, since the chamfered portion 3a is formed on the open end of the reference pin hole 3, engagement of the reference pin holes 3 and 4 with the reference pins 15 and 16 can be facilitated, that is, the plate 1 can be easily gripped.

After the leading end of the plate 1 is gripped, when the plate cylinder 6 is rotated about one revolution, the plate 1 is wound on the circumferential surface of the plate cylinder 6. Then, when the cam shaft 23 of the trailing-side plate lockup device 8 is rotated to set the notch 23a of the cam shaft 23 to correspond to the end portion of the gripper plate 20, the gripper plate 20 is swung by the spring member (not shown) to open. The trailing end of the plate 1 is inserted between the gripper surfaces 20a and 21a, and the reference pin hole 5 is engaged with the reference pin 24. When the cam shaft 23 is rotated to urge the gripper plate 20 by its arcuated portion, the gripper plate 20 is closed to grip the plate 1 with the gripper surfaces 20a and 21a. In this case, since the chamfered portion 5a is formed at the open end of the reference pin hole 5, engagement of the reference pin hole 5 with the reference pin 24 can be facilitated, that is, the plate 1 can be easily gripped. When the plate 1 is mounted in this manner, it is positioned in the lateral direction by the engagement of the reference pins 15 and 24 with the reference pin holes 3 and 5. When the bottom surfaces of the reference pin holes 3 and 4 are caused to abut against the reference pins 15 and 16, respectively, the plate 1 is positioned in the circumferential direction and mounted on the plate cylinder 6.

In this embodiment, the reference pins 15, 16, and 24 are supported by the plate lockup devices 7 and 8 of the plate cylinder 6 in advance. However, reference pins 15, 16, and 24 may be provided independently of the plate lockup devices 7 and 8, and when the plate 1 is to be gripped, the reference pins 15, 16, and 24 may be inserted in the opposite directions through holes formed in a gripper plate 20 and urged into reference pin holes 12b and 21b.

As is apparent from the above description, according to the present invention, the reference pin holes in the ends of the plate are open to the corresponding ends, and the openings are chamfered to spread toward the open ends. Therefore, when the plate is to be mounted on the plate cylinder, even if the positions of the reference pin holes relative to the reference pins deviate more or less, the reference pin holes are guided by the chamfered portions to be engaged with the reference pins. Therefore, mounting is facilitated, reducing physical and mental strain. Also, the preparation time is shortened, improving the operating efficiency of the printing press. Since the opening portions of the reference pin holes are not bent, catching of a bent portion and a gripper surface does not occur, and automatization of plate exchange will not be impeded.

**Claims**

1. A plate characterized by comprising:

   reference pin holes (3, 5) formed in ends of said plate (1) to engage with reference pins (15, 24) of a plate cylinder (6); and

   chamfered portions (3a, 5a) formed to spread toward open ends of the reference pin holes.

2. A plate according to claim 1, wherein the reference pin holes (3, 5) arranged in U-shaped form tightly fitting on said reference pins.

3. A plate according to claim 1, wherein the diameter of each of the reference pin holes is set slightly larger than the diameter of each of said reference pins.

4. A plate according to any one of claims 1 to 3, wherein first and second reference pin holes (3, 5) having said chamfered portions (3a, 5a) are formed at one of right and left symmetrical positions of a leading end (1a) of said plate (1) and at the central position of a trailing end (1b) of said plate, respectively, a square-shaped third reference pin hole (4) is formed at the other one of the right and left symmetrical positions of said leading end of said plate to have a gap with respect to said reference pin (16) in a widthwise direction and to open in an end of said plate, said first and second reference pin holes allow positioning of said plate in the lateral direction, and the first and third reference pin holes allow positioning of said plate in the circumferential direction.

F I G.1

F I G.2

24    6a    6

15    16

# F I G.3

7  11
11a  12a  10  14  14a
13          14b
1
15
12          6
12b         9
17          6a

# F I G.4

8  23  23b  19  20  21a
23a          24  20a  1
6          21b
18          22
6a          21

# F I G.5

EP 0 520 598 A1

**European Patent Office**

**EUROPEAN SEARCH REPORT**

Application Number

EP 92 25 0169

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | FR-A-2 610 853 (AKIYAMA PRINTING MACHINERY MFG. CORP. ET AL.) | 1 | B41F27/00 G03F9/00 |
| Y | * page 9, line 16 - page 10, line 16; figure 4C * | 4 | |
| Y | PATENT ABSTRACTS OF JAPAN vol. 9, no. 282 (M-428)(2005) 9 November 1985 & JP-A-60 124 250 ( KOMORI INSATSU KIKAI K.K. ) 3 July 1985 * abstract * | 4 | |
| A | US-A-3 882 775 (LYTLE ET AL.) | | |
| A | DE-A-3 019 595 (GRAPHP-METRONIC MEâ- UND REGELTECHNIK GMBH.) | | |

TECHNICAL FIELDS SEARCHED (Int. Cl.5)

B41F
G03F

The present search report has been drawn up for all claims

| Place of search | Date of completion of the search | Examiner |
|---|---|---|
| THE HAGUE | 06 OCTOBER 1992 | DIAZ-MAROTO V. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

7